# EUROPEAN PATENT SPECIFICATION

(11) **EP 3 495 318 B1**
(45) Date of publication and mention of the grant of the patent: **07.10.2026**
(21) Application number: 18210961.1
(22) Date of filing: 07.12.2018
(51) Int. Cl.: B81B 7/00, B81C 1/00

(54) **SEMICONDUCTOR PACKAGE WITH AIR CAVITY**
HALBLEITERGEHÄUSE MIT LUFTHOHLRAUM
BOÎTIER SEMICONDUCTEUR DOTÉ D'UNE CAVITÉ D'AIR

(30) Priority: 08.12.2017 US 201762596177 P
(43) Date of publication of application: 12.06.2019
(73) Proprietor: Infineon Technologies AG, 85579 Neubiberg (DE)
(72) Inventor: CHIANG, Chau Fatt, 76450 Melaka (MY); CHUA, Kok Yau, 75050 Melaka (MY); KUEK, Hsieh Ting, 75200 Melaka (MY); BAKAR, Roslie Saini bin, 76100 Durian Tunggal (MY); ABDUL WAHID, Junny, 75450 Melaka (MY); CHONG, Hock Heng, 75350 Melaka (MY); POK, Pei Luan, 75350 (MY); LEE, Chee Hong, 76450 Melaka (MY); SCHMALZL, Stefan, 82054 Sauerlach (DE); REISS, Werner, 83064 Raubling (DE); CHIN, Kon Hoe, 31550 Perak (MY); LIEW, Soon Lee, 31400 Ipoh (MY); OTHMAN, Nurfarena, 76100 Melaka (MY); TUAZON BERNARDEZ, April Coleen, 75200 Melaka (MY)
(74) Representative: Lambsdorff & Lange Patentanwälte Partnerschaft mbB

(56) References cited:
- WO-A1-2010/080068
- US-A1- 2010 044 808
- US-A1- 2010 207 257
- US-A1- 2013 050 227
- US-A1- 2016 155 728
- US-A1- 2016 190 107
- US-B1- 6 534 876

## Description

### BACKGROUND

Two or more semiconductor chips (dies) are often integrated in the same package, e.g., in the case of a power transistor die and a driver die, a sensor die and a controller die, etc. Some conventional multi-chip packaging solutions use multiple PCBs (printed circuit boards) to stack chips, which increases overall packaging cost. Chip stacking also has increased manufacturing complexity. For example, a high precision wire bond technique may be needed which is costly. Also, the likelihood of chip damage increases due to the complex manufacturing process. Other conventional solutions use chip embedding. Chip embedding also is complex, and involves a serial manufacturing process. Chip embedding offers no flexibility in chip variation once a chip is fixed in place. Chip embedding may suffer from artificially high yield loss since a good chip will be lost if a faulty package cannot be reworked.

Some package solutions require a cavity, e.g., in the case of a MEMS (microelectromechanical systems) sensor solution. The membrane of a MEMS sensor should not be contacted by the encapsulation material for the package. A metal lid may be used to cover and protect the MEMS sensor, but increases package height. A Si lid may instead be attached by silicone to cover and protect the MEMS sensor, but increases package cost. Silicone glue may instead be used to cover and protect the MEMS sensor, but may bleed which is hard to control.

US 2016/0155728 A1 shows a stacked packaging using reconstituted wafers. Each reconstituted wafer is formed separately comprising a chip and a redistribution layer each. After the reconstituted wafers are stacked on top of each other, a conductive via may be formed through both wafers electrically coupling the redistribution layers which each other. US 2016/0190107 A1 shows a package where chips are attached to opposite sides of a substrate and this unit is fully encapsulated with conductive vias formed through the encapsulating layer to reach the substrate.

Thus, there is a need for improved chip-packages.

### SUMMARY

A chip-package according to the invention is defined in claim 1.

An upper half or a lower half of the via is plated by the electrically conductive material, and the other half of the via is either devoid of the electrically conductive material or plated by the electrically conductive material providing a thermal conduction path to the other side of the carrier.

The first chip and the second chip may be vertically aligned.

The chip-package may further comprise a metallization layer located on the first portion or the second portion of the encapsulation, wherein the metallization layer comprises a metal pad and a metal trace which connects the metal pad to the electrically conductive material at a first end of the via, and wherein the electrically conductive material electrically contacts the carrier at a second end of the via opposite the first end.

A ratio of a depth of the via to a width of the via may be greater than 1:1.

The electrically conductive material may fill the via in the first portion or the second portion of the encapsulation.

The chip-package may further comprise a solder bump electrically contacting the electrically conductive material at a first end of the via, wherein the electrically conductive material electrically contacts the carrier at a second end of the via opposite the first end.

The chip-package may further comprise a cavity between the first chip and the carrier, or between the second chip and the carrier.

According to an example of a chip-package not covered by the invention, the chip-package comprises: a carrier having a first side and a second side opposing the first side; a first chip coupled to the first side of the carrier; an encapsulation which at least partially encloses the first chip on the first side of the carrier; a cavity between the first chip and the carrier; a glue laterally surrounding the first chip and partly defining the cavity; and one or more vent holes formed in the carrier and providing a passage to the cavity. The chip-package may further comprise a material at least partly filling the one or more vent holes to close off the passage. Separately or in combination, the material at least partly filling the one or more vent holes may comprise solder, a Cu pillar, a SnAg bump, glue and/or epoxy.

According to an example of a chip-package not covered by the invention, the chip-package comprises: a carrier with a first side; a first chip coupled to the first side of the carrier by a coupling structure, wherein the coupling structure provides a distance between the first chip and the carrier; and an encapsulation on the first side of the carrier, wherein the encapsulation is at least partially laterally spaced apart from the first chip as to form a gap between the first chip and the encapsulation, wherein the gap extends to the first side of the carrier. The gap may comprise an air gap. Separately or in combination, the chip-package may further comprise a material in the gap between the first chip and the encapsulation, wherein a cavity is formed by the material in the gap, the carrier and the chip.

Those skilled in the art will recognize additional features and advantages upon reading the following detailed description, and upon viewing the accompanying drawings.

### BRIEF DESCRIPTION OF THE FIGURES

The elements of the drawings are not necessarily to scale relative to each other. Like reference numerals designate corresponding similar parts. The features of the various illustrated embodiments can be combined unless they exclude each other. Embodiments are depicted in the drawings and are detailed in the description which follows.
Figure 1 illustrates a side perspective view of an example of a chip-package having an arrangement of stacked chips.
Figures 2A and 2B illustrate the chip-package 100 at different stages of manufacturing.
Figure 3 illustrates a cross-sectional view of the chip-package of Figure 1 with a material provided in a lateral gap between a chip and an encapsulation.
Figure 4 illustrates a cross-sectional view of the chip-package of Figure 1 with a material provided in the lateral gap between the chip and the encapsulation, according to an example.
Figures 5A through 5G illustrate different views of an embodiment of a chip-package according to the invention having an arrangement of stacked chips.
Figures 6A and 6B illustrate an example of sealing a cavity of a chip-package.
Figure 6C illustrates an image of an actual exemplary package having a cavity sealed formed by the method shown in Figures 6A and 6B.
Figures 7A and 7B illustrate another example of sealing a cavity of a chip-package.
Figure 8 illustrates a cross-sectional view of an example of a chip-package carrier having one or more vent holes.
Figures 9A through 9C illustrate an example of forming vent holes in a chip-package carrier.
Figure 10A illustrates a top-down plan view of a PCB-based carrier without vent holes in the chip-package carriers, and Figure 10B illustrates a top-down plan view of the same PCB-based carrier with vent holes in the carriers.
Figures 11A through 11D illustrate different views of another embodiment of a chip-package having an arrangement of stacked chips.
Figure 12 illustrates a side perspective view of another embodiment of a chip-package having an arrangement of stacked chips.

### DETAILED DESCRIPTION

The embodiments described herein provide chip-packages and corresponding methods of manufacture. The chip-package has one or more vias which extend through entire thickness of the package. One half of the via(s) may be used for electrical connections to a chip included in the package. The other half of the via(s) may provide a thermal conduction path at the opposite side of the package. This half of the via(s) may or may not also provide electrical connections, e.g., to the same or different chip included in the package. In some embodiments, the chip-package may have a cavity, e.g., in the case of a MEMS sensor or SAW (surface acoustic wave) filter application. The cavity may be partly defined by a cured solid material, cured glue, etc. In the case of glue being used to partly define the cavity, one or more vent holes may be formed in the carrier for the MEMS sensor to relieve pressure which builds-up in the cavity during curing of the glue. In some embodiments, the chip carrier included in the chip-package may be a lead frame instead of a PCB (printed circuit board) and the package encapsulation may be at least partially laterally spaced apart from the chip as to form a gap between the chip and the encapsulation. Still other embodiments are described. It is to be understood that the features of the various embodiments described herein may be combined with each other, unless specifically noted otherwise. Various examples are provided at the end of this section, as illustrative combinations of the embodiments described herein.

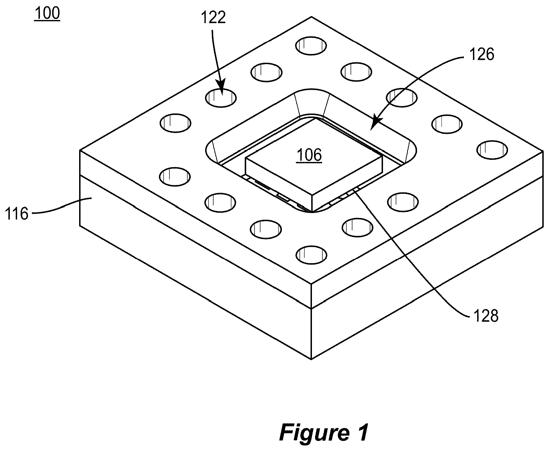

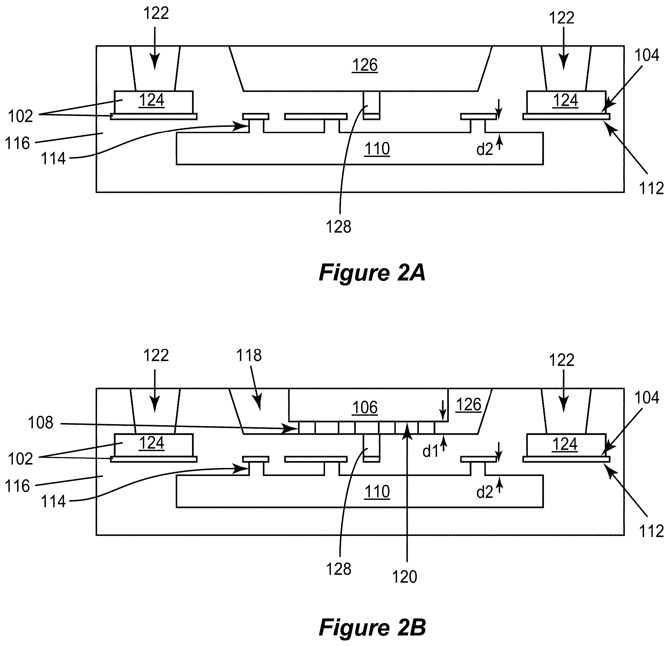

Figure 1 illustrates a side perspective view of an example of a chip-package 100. Figures 2A and 2B illustrate the chip-package 100 at different stages of manufacturing.

The chip-package 100 includes a carrier 102 with a first side 104. In one embodiment, the carrier 102 is a lead frame. A first chip 106 is coupled to the first side 104 of the carrier 102 by a coupling structure 108. The coupling structure 108 may include Cu pillars, filled vias, solder, etc. The coupling structure 108 provides a distance (d1) between the first chip 106 and the carrier 102. The chip-package 100 may include a second chip 110 coupled to the opposing second side 112 of the carrier 102 by a coupling structure 114 which may include Cu pillars, filled vias, solder, etc. and provides a distance (d2) between the second chip 110 and the carrier 102. In one example, the chip-package 100 forms an RF module, the first chip 106 is a MEMS-based tunable filter and the second chip 110 is an RF chip.

An encapsulation 116, such as a mold compound, is provided on the first and second sides 104, 112 of the carrier 102. The encapsulation 116 is at least partially laterally spaced apart from the first chip 106 as to form a lateral gap 118, e.g. an air gap, between the first chip 106 and the encapsulation 116. The lateral gap 118 may extend to the first side 104 of the carrier 102. The lateral gap 118 allows for proper operation of a sensitive area 120 such as a membrane or similar structure in the case of a MEMS-based tunable filter, MEMS sensor, etc., by preventing the encapsulation 116 from impinging upon the sensitive area 120 of the first chip 106.

Figure 2A shows the chip-package 100 after the second chip 110 is coupled to the second side 112 of the carrier 102 and the encapsulation 116 is formed. The second chip 110 is embedded in the encapsulation 116 and coupled to the second side 112 of the carrier 102 by a coupling structure 114. At the side of the encapsulation opposite the second chip 110, vias 122 formed e.g. by laser drilling to expose contact areas 124 of the carrier 102, e.g., leads in the case of a lead frame-based carrier or metal pads in the case of a PCB-based carrier. The vias 122 may be plated or filled, to form electrical connections to the coupling structure 114. A cavity 126 is formed in the side of the encapsulation 116 opposite the second chip 110. For example, in the case of a mold compound as the encapsulation 116, the cavity 126 may be molded into the encapsulation 116 during a standard molding process such as film-assisted molding, transfer molding, injection molding, etc. to form a pre-molded frame which includes the second chip 110. Electrical connections between the second chip 110 and the carrier 102 are formed prior to molding, e.g., via the second coupling structure 114.

Figure 2B shows the chip-package after the first chip 106 is positioned in the cavity 126 and coupled to the carrier 102 by the corresponding coupling structure 108. The cavity 126 is larger than the first chip 106 so that the encapsulation 116 is at least partially laterally spaced apart from the first chip 106, thereby forming a lateral gap 118 such as an air gap between the first chip 106 and the encapsulation 116. Bonds pads 128 of the carrier 102 to which the first chip 106 is to be coupled are exposed in the cavity 126 prior to coupling of the first chip 106. In one embodiment, the first chip 106 has a flip-chip configuration and the coupling structure 108 has Cu pillars or solder bumps which couple the first chip 106 to the exposed bond pads 128 of the carrier 102. Laser direct imaging may be used to expose the bond pads 128 and form the vias 122 in the perimeter of the encapsulation 116. A typical die bond process may be used to land the first chip 106 into the pre-molded frame.

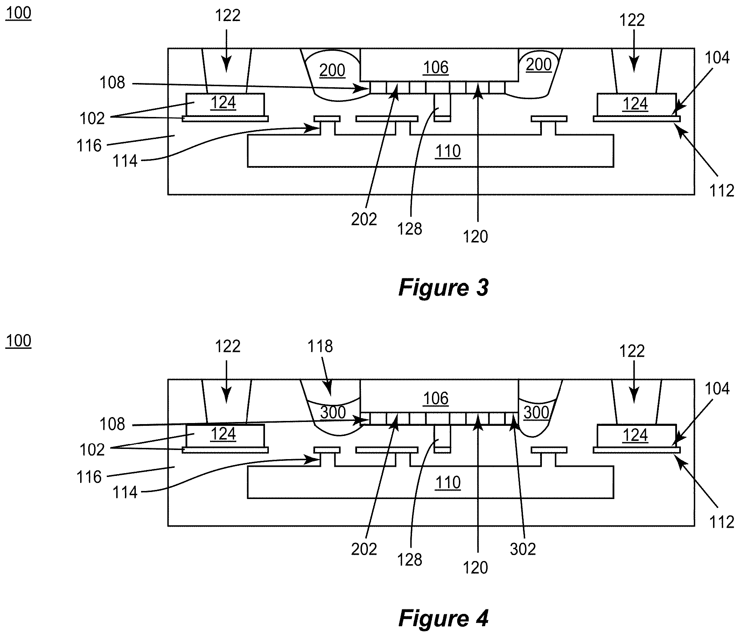

Figure 3 shows the chip-package 100 of Figure 1 after a material 200 is provided in the lateral gap 118 between the first chip 106 and the encapsulation 116. The material 200 fills the perimeter of the lateral gap 118, thereby forming a cavity 202 defined by the material 200 in the gap 118, the carrier 102 and the first chip 106. The cavity 202 may be sealed, depending on the contiguousness and porosity of the material 200 filling the perimeter of the lateral gap 118. In one embodiment, a semisolid material such as polymer clay, high-density insulative rigid foam (PE foam), gel, etc. is dispensed along the perimeter of the lateral gap 118 to fill the empty lateral space between the first chip 106 and the encapsulation 116 but not cover the sensitive area 120 of the first chip 106. The semisolid material may solidify after curing at elevated temperature. For example, polymer clay is essentially PVC (polyvinyl chloride) which is plastic, but until cured, is a very malleable plastic. Polymer clay can be shaped and reshaped a multitude of times without deterioration. Once cured, polymer clay is hard and durable.

Figure 4 shows another example of the chip-package 100 of Figure 1 after a material 300 is provided in the lateral gap 118 between the first chip 106 and the encapsulation 116. As described above in connection with Figure 3, a semisolid material such as polymer clay, high-density insulative rigid foam (PE foam), gel, etc. may be dispensed along the perimeter of the lateral gap 118 to fill the empty space but not cover the sensitive area 120 of the first chip 106, and then solidified by curing at elevated temperature.

The shape of the material 200/300 post-curing may differ depending on the type of material used, the manner in which the material 200/300 is dispensed and shaped, etc., as shown in Figures 3 and 4. For example, the top surface of the material 200 in Figure 3 has a convex shape, the top surface of the material 300 in Figure 4 has a concave shape, or the material 200/300 may have yet another shape (e.g., flat, undulating, etc.). The material 200 in Figure 3 laterally extends to the outermost part of the coupling structure 108 for the first chip 106. The material 300 in Figure 4 terminates laterally before reaching the outermost part of the coupling structure 108, so that there is a lateral gap 302 between the material 300 and the outermost part of the coupling structure 108.

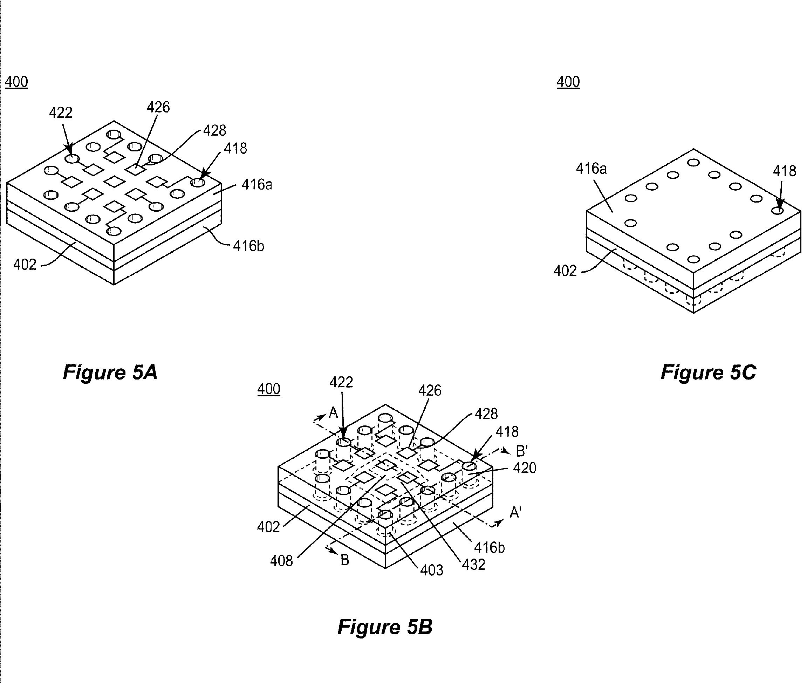

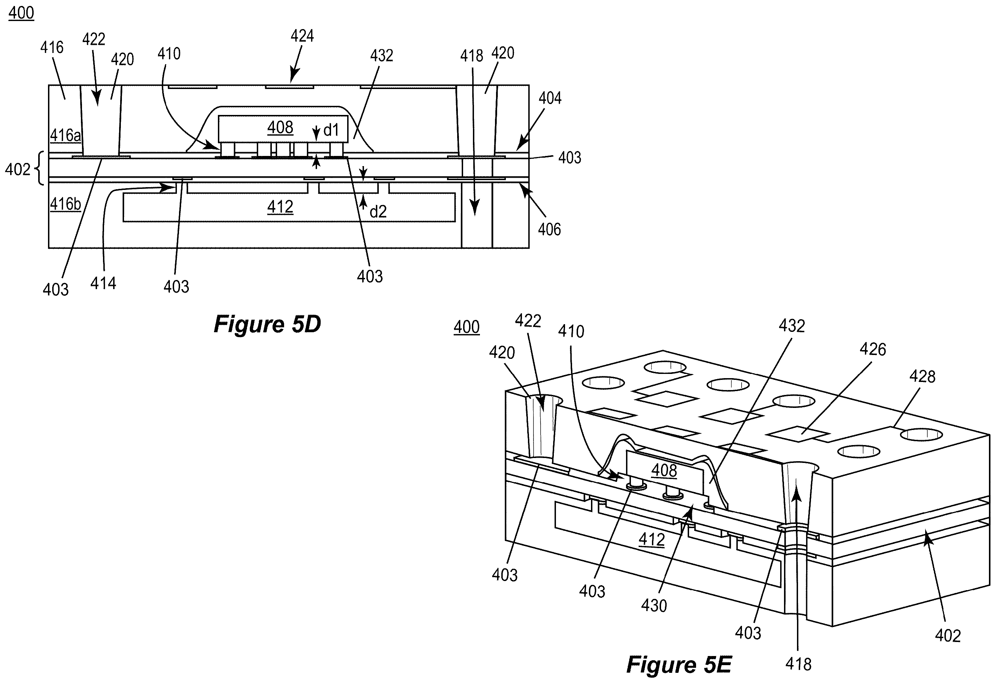

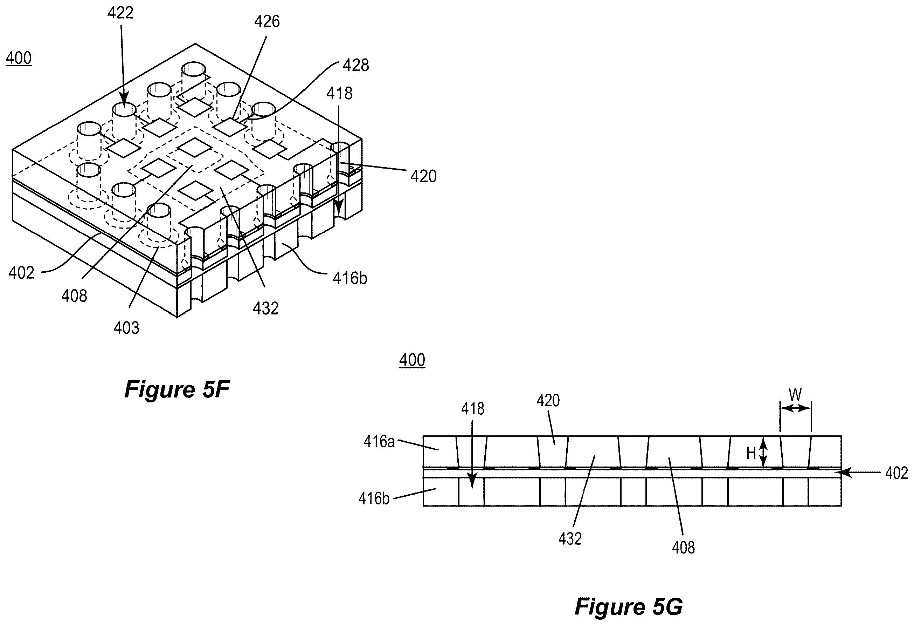

Figures 5A through 5G illustrate an embodiment of a chip-package 400 according to the invention having an arrangement of stacked chips. Figure 5A shows a top-side perspective view of the chip-package 400, Figure 5B shows the same view as Figure 5A but with certain internal details of the package 400 in view, and Figure 5C shows a bottom-side perspective view of the chip-package 400. Figure 5D shows a cross-sectional view of the chip-package 400 along the line labelled A-A' in Figure 5B, and Figure 5E shows a corresponding side perspective view of the chip-package 500 of the cross-section shown in Figure 5D. Figure 5F shows a cross-sectional perspective view of the chip-package 500 taken along the line labelled B-B' in Figure 5B, and Figure 5G shows a corresponding side view of the chip-package 500 along the cross-sectioned plane illustrated in Figure 5F.

According to the embodiment illustrated in Figures 5A through 5G, the chip-package 400 includes a carrier 402, such as a PCB, having a first side 404 and a second side 406 opposing the first side 404. A first chip 408 is coupled to the first side 404 of the carrier 402 by a coupling structure 410. The coupling structure 410 may include Cu pillars, filled vias, solder, etc. The coupling structure 410 provides a distance (d1) between the first chip 408 and the carrier 402. A second chip 412 is coupled to the second side 406 of the carrier 402 by a coupling structure 414 which may include Cu pillars, filled vias, solder, etc. and provides a distance (d2) between the second chip 412 and the carrier 402. The chips 408, 412 may be vertically aligned, reducing the parasitic inductance and resistance of the package 400 and yielding a leadless package on both sides with surface I/O and having a small footprint. For example, the distance between the chips 408, 412 can be shortened by 50% and/or the footprint of the package 400 can be reduced by 40%.

The chip-package 400 also includes an encapsulation 416 with a first portion 416a and a second portion 416b. The first portion 416a of the encapsulation 416 at least partially encloses the first chip 408 at the first side 404 of the carrier 402, and the second portion 416b of the encapsulation 416 at least partially encloses the second chip 412 at the second side 406 of the carrier 402. One or more vias 418 extend through the first portion 416a of the encapsulation 416, the carrier 402 and the second portion 416b of the encapsulation 416. An electrically conductive material 420 at least partly covers a sidewall of some or all of the vias 420 in the first portion 416a or the second portion 416b of the encapsulation 416, to electrically contact metal contact areas 403 of the carrier 402 at either the first side 404 or the second side 406.

The electrically conductive material 420 is formed by plating the upper half or the lower half of the vias 418. The other half of the vias 418 may be devoid of the electrically conductive material 420. For example, the upper or lower half of the vias 418 may be pre-coated so that a plating solution does not adhere / plate this part of the vias 418. A mold compound is mixed with metal powder and insulation material to enable plating of the other half of the vias 418. A laser may be used to remove / burn-off the insulation material that insulates the metal powder to expose the metal, allowing the plating material to plate the metal. The coating remaining on the other part of the sidewall ensures the plating solution effectively passes through the vias 418.

In another embodiment, both the upper half and the lower half of the vias 418 are plated by the electrically conductive material 420. The upper or lower plated half of one or more of the vias 418 electrically contacts metal contact areas 403 of the carrier 402 at one of the sides 404, 406 of the carrier 402, and the other plated half provides a thermal conduction path to the other side 406, 404 of the carrier 402. Figures 5D through 5G show only the upper half of the vias 418 plated by the electrically conductive material 420, however, the lower half may instead be plated, or both halves may be coated, e.g., omitting the pre-coating step described above.

Regardless of whether only one half or both halves of the vias 418 are plated with the electrically conductive material 420, a targeted laser may be used to form relatively small vias 418. The ratio of the depth / height (H) of the vias 418 to the width (W) of the vias 418 may be greater than 1:1, e.g., greater than 10:1. For example, the via height (H) may be 1mm and the width (W) may be 0.1mm. Other vias 422 may be formed which extend to the carrier 402 through either the first portion 416a or the second portion 416b of the encapsulation, but not through both portions 416a, 416b. These vias 422 may be coated with the same or different electrically conductive material 420, and may electrically contact metal contact areas 403 of the carrier 402 at one side 404/406.

A metallization layer 424 may be located on the first portion 416a or the second portion 416b of the encapsulation 416. Each metallization layer 424 may include metal pads 426 and respective metal traces 428. The metal pads 426 provide I/O interconnection points for the package 400. The metal traces 428 connect the corresponding metal pads 426 to the electrically conductive material 420 at a first end of a via 418/422, and the electrically conductive material 420 electrically contacts a metal contact area 403 of the carrier 402 at a second end of the via 418/422 opposite the first end.

The chip-package 400 may further include a cavity 430 between the first chip 408 and the carrier 402, or between the second chip 412 and the carrier 402. In one embodiment, the chip-package 400 is a QFP (quad flat package) which forms an RF module, the first chip 408 is a MEMS-based tunable filter and the second chip 412 is an RF chip. According to this embodiment, the cavity 430 is provided between the MEMS-based tunable filter and the carrier 402. The cavity 430 may be sealed by a material 432 disposed in the cavity 430 and which surrounds the periphery of the first chip 408.

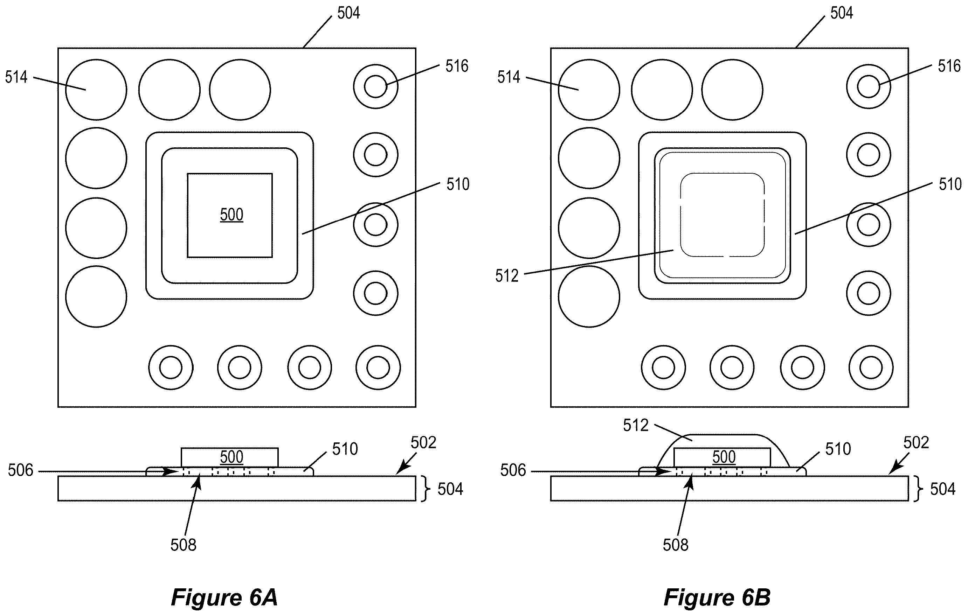

Figures 6A and 6B illustrate an example of sealing a cavity of a chip-package. Figures 6A and 6B each show a top-down plan view and corresponding cross-sectional view during different stages of the cavity sealing method. According to the example illustrated in Figures 6A and 6B, the cavity is sealed prior to application of the chip-package encapsulation. Figure 6A shows a first chip 500 coupled to the first side 502 of a carrier 504 by a coupling structure 506. In one embodiment, the first chip 500 is a SAW filter chip and the resulting package forms an RF module. The SAW filter chip 500 may have a flip-chip configuration and a cavity 508 between the first chip 500 and the carrier 504 is sealed by a 2-part gluing process.

Figure 6A shows the first part of the gluing process, in which a ring of glue 510 is dispensed on the carrier 504 around the perimeter of the first chip 500. In one embodiment, the ring of glue 510 has a thixotropy in a range between 3.5 and 4.0.

Figure 6B shows the second part of the gluing process, in which a glob of glue 512 is dispensed on the first chip 500 within the perimeter defined by the ring of glue 510. Such a process is commonly referred to as glob-top. In one example, the glob of glue 512 has a thixotropy in a range between 3.5 and 4.0. For example, the ring of glue 510 may have a thixotropy of about 3.5 and the glob of glue 512 may have a thixotropy of about 4.0. The ring of glue 510 together with the glob of glue 512 form a glue-based sealing structure which seals the air cavity 508, preventing mold compound from seeping under the first chip 500 during a subsequent mold process such as film-assisted molding, transfer molding, injection molding, etc. In one embodiment, the glues 510, 512 used to seal the cavity 508 each comprise a silicone material such as silicone die attach material KJR 9602 series sold by Shin-Etsu MicroSi. The resulting glue-on-glue cavity sealing structure allows for reduced package size, and the use of epoxy-based glues provides better adhesion as compared to Si and metal lids. The carrier 504 may have various metal pads 514 and conductive vias 516, to facilitate electrical connections to the package and first chip 500.

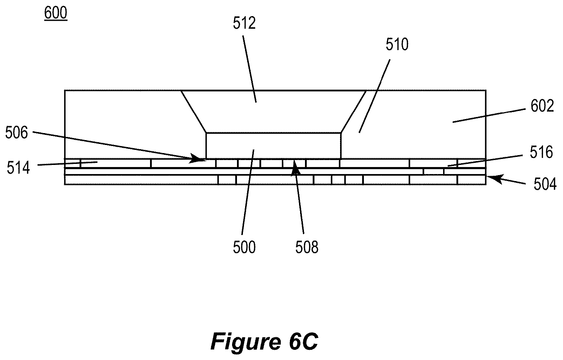

Figure 6C shows an image of an actual exemplary package 600 having a cavity sealed 508 formed by the method shown in Figures 6A and 6B. The glues 510, 512 together form a glue-based sealing structure which seals the air cavity 508, preventing mold compound 602 from seeping under the first chip 500 during a subsequent mold process such as film-assisted molding, transfer molding, injection molding, etc. The glue-based sealing structure formed by the glues 510, 512 laterally surrounds the first chip 500 and, together with the chip 500 and the carrier 504, defines the cavity 508 between the carrier 504 and the chip 500.

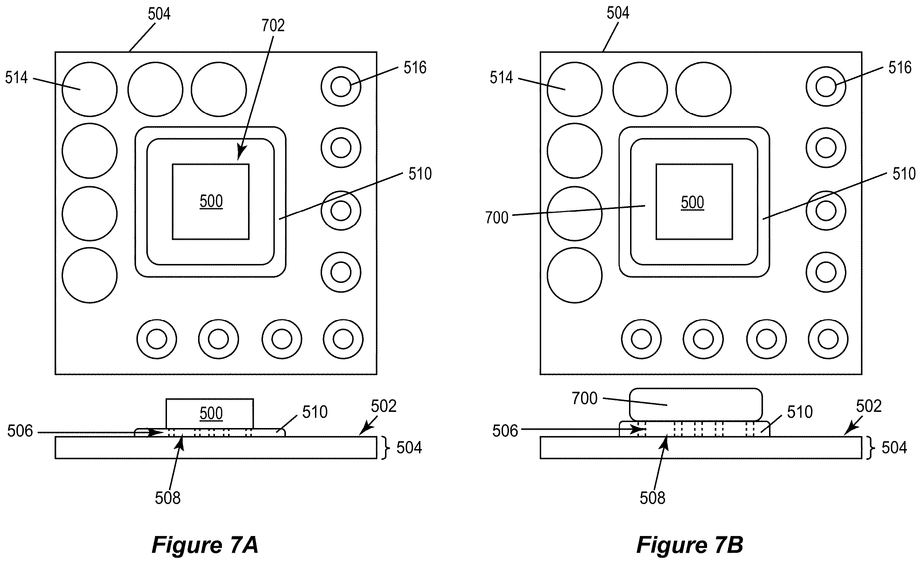

Figures 7A and 7B illustrate another example of sealing a cavity of a chip-package. Figures 7A and 7B each show a top-down plan view and corresponding cross-sectional view during different stages of the cavity sealing method. The embodiment shown in Figures 7A and 7B is similar to the embodiment illustrated in Figures 6A and 6B. Different, however, a glue writing/printing process is used instead of a glob-top process. Similar to Figure 6A, Figure 7A shows a ring of glue 510 dispensed on the carrier 504 around the perimeter of the first chip 500. Figure 7B shows the second part of the gluing process, in which a second ring of glue 700 is dispensed into the gap 702 between the first chip 500 and the first ring of glue 510. Different than the example shown in Figure 6B, the second ring of glue 700 is dispensed by a standard writing/printing process instead of a glob top process. For example, the second ring of glue 700 may be printed by either screen or stencil.

The glue-based cavity sealing structures described herein may be subject to pressure that build-ups during the glue curing process. If unmitigated, the pressure may cause the glue-based sealing structure to bulge and possibly rupture, providing a path for encapsulation material to subsequently enter. The cavity may be partly or completely filled with the encapsulation material if the glue-based cavity sealing structure ruptures, rendering the chip adjacent the filled cavity ineffective for its intended use. For example, a MEMS-based pressure sensor or SAW filter would function poorly if at all if a mold compound entered the cavity and solidified against the sensitive area of the chip.

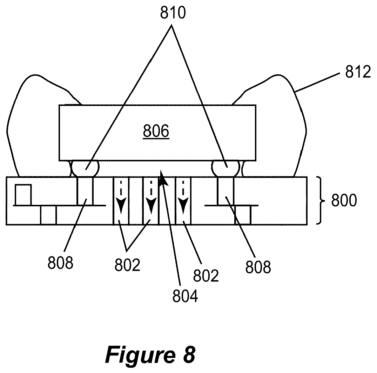

Figure 8 illustrates a cross-sectional view of an example of a carrier 800 which has one or more vent holes 802 for providing a passage to a cavity 804 formed between the carrier 800 and a chip 806 coupled to electrically conductive regions 808 of the carrier 800 by a coupling structure 810. A glue-based cavity sealing structure 812, e.g. of the kind previously described herein in connection with Figures 6A-6B or 7A-7B, seals the cavity 804 between the carrier 800 and the chip 806. The vent hole(s) 802 remain unplugged during the glue curing process, so that pressure which builds-up in the cavity 804 during glue curing can escape through the vent hole(s) 802. The escaping gas is illustrated as downward dashed arrows in Figure 8.

The passage formed by the vent hole(s) 802 may be sealed at the exit side after completion of the glue curing, e.g., to prevent encapsulation material from subsequently entering the cavity 804 through the vent hole(s) 802. For example, a material (not shown) may at least partly fill the vent hole(s) 802 to close off the passage. The material at least partly filling the vent hole(s) 802 may comprises solder, a Cu pillar, a SnAg bump, glue and/or epoxy, etc. The passage formed by the vent hole(s) 802 may be designed to be resistant towards the air path sealing material, for example, with a partially or fully coated finish, and not limited to a copper finish with solder deposition to cover, gold finish for chip sealing, glue material, etc.

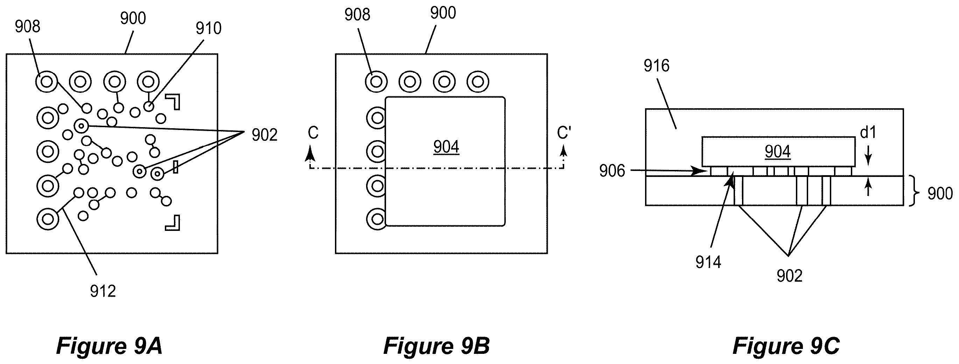

Figures 9A through 9C illustrate an example of forming vent holes in a carrier. Figure 9A shows a top plan view of the carrier 900 after vent holes 902 are formed in the carrier 900, and before a chip 904 is coupled to the carrier 900 by a coupling structure 906. The carrier 900 may include plated through-holes 908 for providing electrical connections between both sides of the carrier 900. The carrier 900 may also include metal pads 910 connected by metal traces 912 to the plated through-holes 908. The carrier 900 further includes vent holes 902. The vent holes 902 may be formed in the same way as the through-holes 908, e.g., by laser drilling, mechanical drilling using a drill bit, etc. The vent holes 902 may or may not be plated. Figure 9B shows the carrier 900 after the chip 904 is coupled to the carrier 900 by the coupling structure 906. The coupling structure 906 may include Cu pillars, filled vias, solder, etc. and provides a distance (d1) between the first chip 904 and the carrier 900, as previously described herein. The coupling structure 906 is connected to the metal pads 910 of the carrier 900. Figure 9C is a cross-sectional view along the line labelled C-C' in Figure 9B. As shown in Figure 9C, the vent holes 902 remain unplugged until after the cavity 914 between the carrier 900 and the chip 904 is sealed, e.g., using a glue-based cavity sealing structure 916 of the kind previously described herein in connection with Figures 6A-6B or 7A-7B. The glue-based sealing structure 916 at least laterally surrounds the chip 904, and together with the chip 904 and the carrier 900, defines the cavity 914 between the carrier 900 and the chip 904. Pressure which builds-up in the cavity 914 during the glue curing process escapes through the vent holes 902. The vent holes 902 may be filled/sealed after completion of the glue curing, e.g., as previously described herein.

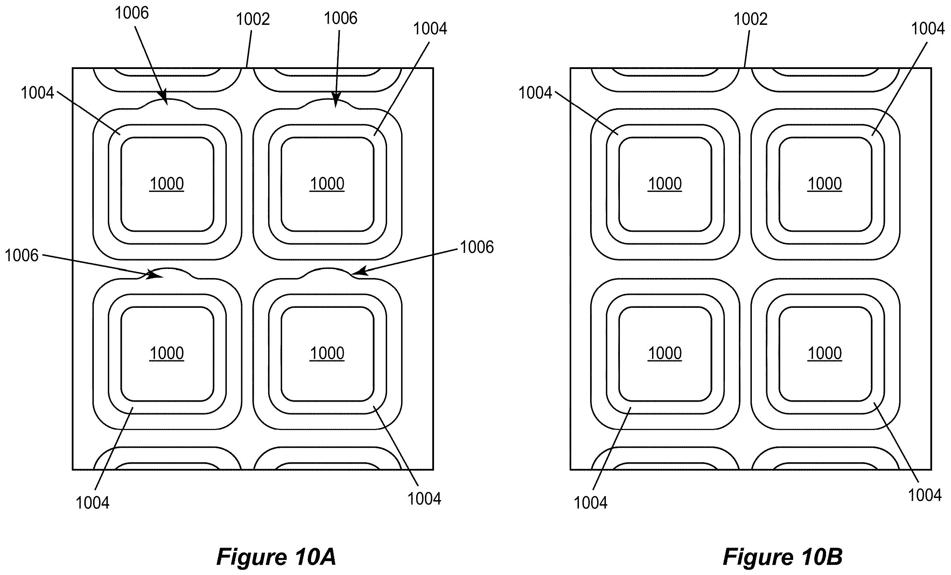

Figure 10A illustrates a top-down plan view of a plurality of chips 1000 coupled to a PCB-based carrier 1002. A glue-based sealing structure 1004 is provided for each chip 1000, to seal the cavity between the carrier 1002 and the respective chips 1000. The carrier 1002 shown in Figure 10A does not include vent holes for releasing pressure during the glue curing process. Bulges 1006 in the glue-based sealing structures 1004 are plainly evident in Figure 10A. The glue curing process was performed at 150C for 2 hours in this example, and the bulging began to occur at 35C and continued even after the curing conditions were removed.

Figure 10B illustrates a top-down plan view of the same PCB-based carrier 1002 as shown in Figure 10A, but vent holes which are out of view in Figure 10B below the chips 1000 are formed in the carrier 1002 as previously described herein. The vent holes provide a passage to the respective cavities under the chips 1000, allowing pressure which builds-up during the glue curing process to escape. The glue-based sealing structures 1004 in Figure 10B did experience bulging during the same curing conditions as in Figure 10A. The vent holes may be filled/sealed after the glue curing process, as previously described herein.

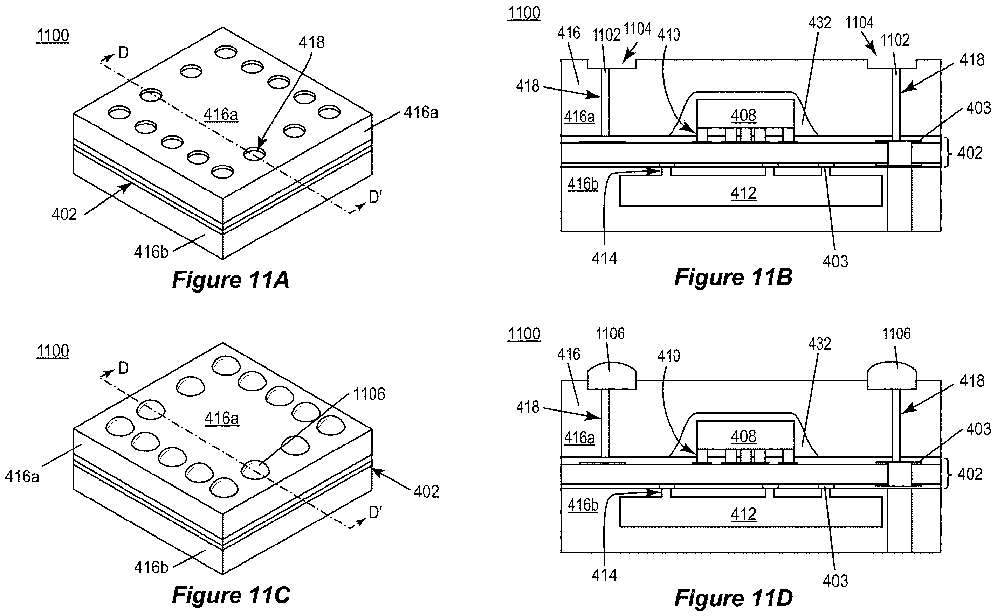

Figures 11A through 11D illustrate another embodiment of a chip-package 1100 having an arrangement of stacked chips 408, 412. The embodiment shown in Figures 11A through 11D is similar to the embodiment illustrated in Figures 5A through 5G. Different, however, the electrically conductive material 420 fills the vias 418 in the periphery of the upper portion 116a of the encapsulation 116 to form wire-like conductors 1102. A notch or recess 1104 may be formed in the outer side of the encapsulation material 416 at which the wire-like conductors 1102 terminate. A solder bump 1106 may be formed in each notch/recess 1104 for electrically contacting the wire-like conductors 1102 at a first end of the vias 418. The wire-like conductors 1102 contact the carrier 402 at a second end of the vias 418 opposite the first end. Figure 11A shows the chip-package 1100 after the notches/recesses 1104 are formed in the encapsulation 416, but before via plating and before solder bump formation. Figure 11B shows a corresponding cross-sectional view along the line labeled D-D' in Figure 11A, but after via plating. Figure 11C shows the chip-package 1100 after the solder bumps 1106 are formed in the notches/recesses 1104 in the encapsulation 416, and Figure 11D shows a corresponding cross-sectional view along the line labeled D-D' in Figure 11C.

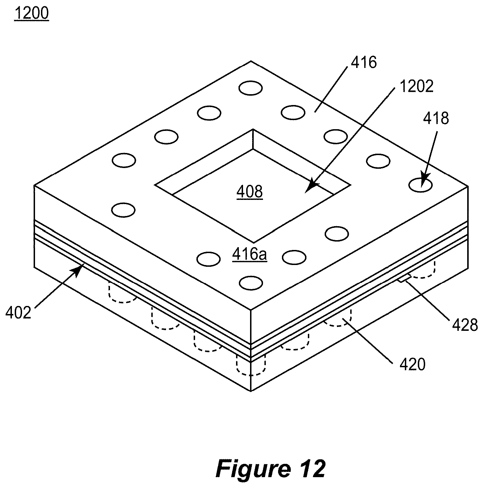

Figure 12 illustrates a side perspective view of another embodiment of a chip-package 1200 having an arrangement of stacked chips. The embodiment shown in Figure 12 is similar to the embodiment illustrated in Figures 11A through 11D. Different, however, the chip 408 adjacent the sealed cavity has an exposed surface 1202, which can be readily realized during the encapsulation process. Figure 12 shows certain internal details of the package 1200 in view in the lower part of the package 1200.

Terms such as "first", "second", and the like, are used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise.

## Claims

1. A chip-package (400), comprising:
a carrier (402) having a first side (404) and a second side (406) opposing the first side (404);
a first chip (106; 408) coupled to the first side (404) of the carrier (402);
a second chip (412) coupled to the second side (406) of the carrier (402);
an encapsulation (416) with a first portion (416a), which at least partially encloses the first chip (408) on the first side (404) of the carrier (402), and a second portion (416b), which at least partially encloses the second chip (412) on the second side (406) of the carrier (402);
a via (418) extending through the first portion (416a) of the encapsulation (416), the carrier (402) and the second portion (416b) of the encapsulation (416); and
an electrically conductive material (420) at least partly covering a sidewall of the via (418) in the first portion (416a) or the second portion (416b) of the encapsulation (416), to electrically contact the carrier (402) at either the first side (404) or the second side (406); wherein the carrier (402) is a printed circuit board or a leadframe; and wherein
an upper portion of the via (418) extending throughout the first portion (416a) of the encapsulation (416) or a lower portion of the via extending throughout the second portion (416b) of the encapsulation (416) is plated by the electrically conductive material (420), and **characterised in that** the respective other portion of the via (418) is devoid of the electrically conductive material and makes a thermal conduction path.

2. The chip-package (400) of claim 1, wherein an upper portion of the via (418) extending throughout the first portion (416a) of the encapsulation (416) and a lower portion of the via (418) extending throughout the second portion (416b) of the encapsulation (416) are each plated by the electrically conductive material (420), wherein one of the plated portions of the via (418) electrically contacts the carrier (402) at one of the sides (404, 406) of the carrier (402), and wherein the respective other plated portion of the via (418) provides a thermal conduction path to the respective other side (406, 404) of the carrier (402).

3. The chip-package (400) of claim 1, wherein the first chip (408) and the second chip (412) are vertically aligned.

4. The chip-package (400) of claim 1, further comprising a metallization layer (424) located on the first portion (416a) or the second portion (416b) of the encapsulation (416), wherein the metallization layer (424) comprises a metal pad (426) and a metal trace (428) which connects the metal pad (426) to the electrically conductive material (420) at a first end of the via (418), and wherein the electrically conductive material (420) electrically contacts the carrier (402) at a second end of the via (418) opposite the first end.

5. The chip-package (400) of claim 1, wherein a ratio of a depth of the via (418) to a width of the via (418) is greater than 1:1.

6. The chip-package of claim 1, wherein the electrically conductive material (420) fills the via (418) in the first portion (416a) or the second portion (416b) of the encapsulation (416).

7. The chip-package (400) of claim 6, further comprising a solder bump electrically contacting the electrically conductive material (420) at a first end of the via (418), wherein the electrically conductive material (420) electrically contacts the carrier (402) at a second end of the via (418) opposite the first end.

8. The chip-package of claim 1, further comprising a cavity (508) between the first chip (408) and the carrier (402), or between the second chip (412) and the carrier (402).

## Patentansprüche

1. Chip-Package (400), umfassend:
einen Träger (402) mit einer ersten Seite (404) und einer zweiten Seite (406) gegenüber der ersten Seite (404);
einen ersten Chip (106; 408), der mit der ersten Seite (404) des Trägers (402) gekoppelt ist;
einen zweiten Chip (412), der mit der zweiten Seite (406) des Trägers (402) gekoppelt ist;
eine Verkapselung (416) mit einem ersten Abschnitt (416a), der den ersten Chip (408) auf der ersten Seite (404) des Trägers (402) zumindest teilweise umschließt, und einem zweiten Abschnitt (416b), der den zweiten Chip (412) auf der zweiten Seite (406) des Trägers (402) zumindest teilweise umschließt;
einen Via (418), der sich durch den ersten Abschnitt (416a) der Verkapselung (416), den Träger (402) und den zweiten Abschnitt (416b) der Verkapselung (416) erstreckt; und
ein elektrisch leitfähiges Material (420), das eine Seitenwand des Vias (418) in dem ersten Abschnitt (461a) oder dem zweiten Abschnitt (416b) der Verkapselung (416) zumindest teilweise bedeckt, um den Träger (402) entweder an der ersten Seite (404) oder der zweiten Seite (406) elektrisch zu kontaktieren; wobei
der Träger (402) eine Leiterplatte oder ein Leiterrahmen ist; und wobei
ein oberer Abschnitt des Vias (418), der sich durch den ersten Abschnitt (416a) der Verkapselung (416) erstreckt, oder ein unterer Abschnitt des Vias, der sich durch den zweiten Abschnitt (416b) der Verkapselung (416) erstreckt, durch das elektrisch leitfähige Material (420) plattiert ist, und
**dadurch gekennzeichnet, dass** der jeweilige andere Abschnitt des Vias (418) frei von dem elektrisch leitfähigen Material ist und einen Wärmeleitpfad bildet.

2. Chip-Package (400) nach Anspruch 1, wobei ein oberer Abschnitt des Vias (418), der sich durch den ersten Abschnitt (416a) der Verkapselung (416) erstreckt, und ein unterer Abschnitt des Vias (418), der sich durch den zweiten Abschnitt (416b) der Verkapselung (416) erstreckt, jeweils durch das elektrisch leitfähige Material (420) plattiert sind, wobei einer der plattierten Abschnitte des Vias (418) den Träger (402) an einer der Seiten (404, 406) des Trägers (402) elektrisch kontaktiert, und wobei der jeweilige andere plattierte Abschnitt des Vias (418) einen Wärmeleitpfad zu der jeweiligen anderen Seite (406, 404) des Trägers (402) bereitstellt.

3. Chip-Package (400) nach Anspruch 1, wobei der erste Chip (408) und der zweite Chip (412) vertikal ausgerichtet sind.

4. Chip-Package (400) nach Anspruch 1, ferner umfassend eine Metallisierungsschicht (424), die sich auf dem ersten Abschnitt (416a) oder dem zweiten Abschnitt (416b) der Verkapselung (416) befindet, wobei die Metallisierungsschicht (424) ein Metallpad (426) und eine Metallleiterbahn (428) umfasst, die das Metallpad (426) mit dem elektrisch leitfähigen Material (420) an einem ersten Ende des Vias (418) verbindet, und wobei das elektrisch leitfähige Material (420) den Träger (402) an einem zweiten Ende des Vias (418) gegenüber dem ersten Ende elektrisch kontaktiert.

5. Chip-Package (400) nach Anspruch 1, wobei ein Verhältnis einer Tiefe des Vias (418) zu einer Breite des Vias (418) größer als 1:1 ist.

6. Chip-Package nach Anspruch 1, wobei das elektrisch leitfähige Material (420) den Via (418) in dem ersten Abschnitt (416a) oder dem zweiten Abschnitt (416b) der Verkapselung (416) füllt.

7. Chip-Package (400) nach Anspruch 6, ferner umfassend einen Lötkontakthügel, der das elektrisch leitfähige Material (420) an einem ersten Ende des Vias (418) elektrisch kontaktiert, wobei das elektrisch leitfähige Material (420) den Träger (402) an einem zweiten Ende des Vias (418) gegenüber dem ersten Ende elektrisch kontaktiert.

8. Chip-Package nach Anspruch 1, ferner umfassend einen Hohlraum (508) zwischen dem ersten Chip (408) und dem Träger (402) oder zwischen dem zweiten Chip (412) und dem Träger (402).

## Revendications

1. Boîtier de puces (400) comprenant :
un support (402) ayant un premier côté (404) et un deuxième côté (406) à l'opposé du premier côté (404) ;
une première puce (106 ; 408) couplée au premier côté (404) du support (402) ;
une deuxième puce (412) couplée au deuxième côté (406) du support (402) ;
une encapsulation (416) avec une première partie (416a) qui enveloppe au moins partiellement la première puce (408) sur le premier côté (404) du support (402), et une deuxième partie (416b) qui enveloppe au moins partiellement la deuxième puce (412) sur le deuxième côté (406) du support (402) ;
un trou d'interconnexion (418) s'étendant à travers la première partie (416a) de l'encapsulation (416), le support (402) et la deuxième partie (416b) de l'encapsulation (416) ; et
un matériau électriquement conducteur (420) recouvrant au moins partiellement une paroi latérale du trou d'interconnexion (418) dans la première partie (461a) ou la deuxième partie (416b) de l'encapsulation (416), pour entrer en contact électrique avec le support (402) au niveau du premier côté (404) ou du deuxième côté (406) ;
dans lequel
le support (402) est une carte de circuit imprimé ou une grille de connexion ; et dans lequel
une partie supérieure du trou d'interconnexion (418) s'étendant d'un bout à l'autre de la première partie (416a) de l'encapsulation (416) ou une partie inférieure du trou d'interconnexion s'étendant d'un bout à l'autre de la deuxième partie (416b) de l'encapsulation (416) est revêtue du matériau électriquement conducteur (420), et **caractérisé en ce que** l'autre partie respective du trou d'interconnexion (418) est dépourvue du matériau électriquement conducteur et constitue un chemin de conduction thermique.

2. Boîtier de puces (400) de la revendication 1, dans lequel une partie supérieure du trou d'interconnexion (418) s'étendant d'un bout à l'autre de la première partie (416a) de l'encapsulation (416) et une partie inférieure du trou d'interconnexion (418) s'étendant d'un bout à l'autre de la deuxième partie (416b) de l'encapsulation (416) sont chacune revêtues du matériau électriquement conducteur (420), dans lequel une des parties revêtues du trou d'interconnexion (418) est en contact électrique avec le support (402) au niveau d'un des côtés (404, 406) du support (402), et dans lequel l'autre partie revêtue respective du trou d'interconnexion (418) fournit un chemin de conduction thermique à l'autre côté respectif (406, 404) du support (402).

3. Boîtier de puces (400) de la revendication 1, dans lequel la première puce (408) et la deuxième puce (412) sont alignées verticalement.

4. Boîtier de puces (400) de la revendication 1, comprenant en outre une couche de métallisation (424) située sur la première partie (416a) ou la deuxième partie (416b) de l'encapsulation (416), la couche de métallisation (424) comprenant un plot métallique (426) et une piste métallique (428) qui relie le plot métallique (426) au matériau électriquement conducteur (420) à une première extrémité du trou d'interconnexion (418), et le matériau électriquement conducteur (420) étant en contact électrique avec le support (402) à une deuxième extrémité du trou d'interconnexion (418) à l'opposé de la première extrémité.

5. Boîtier de puces (400) de la revendication 1, dans lequel un rapport entre une profondeur du trou d'interconnexion (418) et une largeur du trou d'interconnexion (418) est supérieur à 1/1.

6. Boîtier de puces de la revendication 1, dans lequel le matériau électriquement conducteur (420) remplit le trou d'interconnexion (418) dans la première partie (416a) ou la deuxième partie (416b) de l'encapsulation (416).

7. Boîtier de puces (400) de la revendication 6, comprenant en outre un plot de soudure en contact électrique avec le matériau électriquement conducteur (420) à une première extrémité du trou d'interconnexion (418), le matériau électriquement conducteur (420) étant en contact électrique avec le support (402) à une deuxième extrémité du trou d'interconnexion (418) à l'opposé de la première extrémité.

8. Boîtier de puces de la revendication 1, comprenant en outre une cavité (508) entre la première puce (408) et le support (402), ou entre la deuxième puce (412) et le support (402).
